# EUROPEAN PATENT SPECIFICATION

(11) **EP 1 658 659 B1**
(45) Date of publication and mention of the grant of the patent: **17.01.2007**
(21) Application number: 04782121.0
(22) Date of filing: 25.08.2004
(51) Int. Cl.: H01R 12/16, H01R 13/658, H05K 9/00

(54) **STACKED SFP CONNECTOR AND CAGE ASSEMBLY**
GESTAPELTER SFP-VERBINDER UND KÄFIGBAUGRUPPE
ENSEMBLE CONNECTEUR SFP EMPILE ET CAGE DE BLINDAGE

(30) Priority: 27.08.2003 US 649238
(43) Date of publication of application: 24.05.2006
(73) Proprietor: TYCO Electronics Corporation, Middletown, Pennsylvania 17057 (US)
(72) Inventor: HENRY, Randall, Robert, Harrisburg, PA 17110 (US); PHILLIPS, Michael, John, Camp Hill, PA 17011 (US)
(74) Representative: Johnstone, Douglas Ian
(86) International application number: PCT/US2004/027561
(87) International publication number: WO 2005/022698

(56) References cited:
- DE-A- 19 640 847
- US-A1- 2002 025 720
- US-A1- 2002 146 926
- US-A1- 2002 197 043
- US-B1- 6 206 725
- US-B1- 6 276 963

## Description

The present invention relates generally to electronic connector systems and, more specifically, to low-profile connector systems for pluggable electronic modules, such as transceiver modules for high speed fiber optical and copper communications.

It is known to provide a metal cage with a plurality of ports that can each receive a pluggable electronic module such as that disclosed in U.S. Patent 6,517,382. In fact, several pluggable module designs and standards have been introduced in which a pluggable module plugs into a receptacle which is electronically connected to a host circuit board. For example, a well-known type of transceiver developed by an industry consortium is known as a gigabit interface converter (GBIC) or serial optical converter (SOC) and provides an interface between a computer and a data communication network such as Ethernet or Fibre Channel. These standards offer a generally robust design which has been well received in industry.

Although these conventional pluggable designs have been used successfully in the past, they tend to be unsuitable for miniaturization which is an ever-constant objective in the industry. It is desirable to miniaturize transceivers in order to increase the port density associated with the network connection, such as, for example, switch boxes, cabling patch panels, wiring closets, and computer input/output (I/O). Recently, a new standard has been promulgated and is referred to herein as the small form factor pluggable (SFP) standard which specifies an enclosure height of 9.8 mm and a width of 13.5 mm and a minimum of 20 electrical I/O connections. In addition to miniaturizing the module, it is also desirable to increase its operating frequency. For example, applications are quickly moving from the subgigabit realm to well over one gigabit. Conventional pluggable module configurations cannot meet these parameters. It is also desirable to increase the port density and optimize the connection interface for the SFP modules.

Miniaturizing a module while maintaining or even increasing its operating speed presents a number of design problems, particularly in applications in which data transmission rates are high, for example, in the range of 1-10 Gbs (Gigabits/second). Of particular concern is reducing electromagnetic interference (EMI) emissions. Due to government regulations, there is a need not only to minimize the EMI emissions of the module, but also to contain the EMI emissions of the host system in which the module is mounted regardless of whether a module is plugged in to the receptacle.

US Patent No. 6,276,963 shows a conventional design wherein EMI shielding is achieved by using a conductive spring-loaded door which is capable of swinging shut and closing the receptacle when the module is removed. These conventional receptacles also have spring clips to ground the receptacles to the bezel opening of the host system. Providing space for spring-loaded doors and spring clips on the receptacle tends to be problematic if not impossible in miniaturized configurations. Additionally, miniaturized configurations present problems in dissipating heat from the module and incorporating traditional mechanisms for ejecting and retaining the module and for electrically connecting the module to the host circuit board. Further, there is an inherent difficulty in handling very small components that must be assembled in the miniaturized configurations.

Therefore, there is a need for a connection system that conforms to the SFP standard dimensions while minimizing EMI emissions, thereby increasing port density and providing convenient pluggable operation, and that can be assembled without undue difficulty.

This problem is solved by an electrical connector assembly comprising a shielding cage having an upper wall, a lower wall, side walls, a rear wall, and an intermediate wall defining a plurality of module-receiving ports arranged in an array of rows and columns. The lower wall and the intermediate wall form a communication opening between the module-receiving ports in each said column. An electrical connector is disposed in each said communication opening. Each said electrical connector includes an insulative housing having a circuit board mounting face and a front mating face. The front mating face includes upper and lower card-receiving slots extending horizontally across the front mating face and positioned one above the other for alignment with respective upper and lower module-receiving ports in each said column. Each said electrical connector includes a plurality of terminals arranged in an array comprising upper and lower terminal pairs. The upper terminal pair has cantilever beam contacts flanking the upper card-receiving slot, and the lower terminal pair has cantilever beam contacts flanking the lower card-receiving slot. Each terminal array includes a stamped lead frame overmolded with a web of plastic material. A locking tab is overmolded in the web of plastic material, and the locking tab extends outwardly from a front edge of the web and engages in a slot in the housing

The invention will now be described by way of example with reference to the accompanying drawings wherein:

Figure 1 is a perspective view of an underside of an electrical connector assembly including a cage and electrical connectors according to the invention;

Figure 2 is a bottom plan view of the assembly of Figure 1;

Figure 3 is a front perspective view of the cage of Figure 1 less the connectors;

Figure 4 is an underside perspective of the cage of Figure 3;

Figure 5 is a perspective view of one of the connectors shown in Figure 1;

Figure 6 is a side plan view of the connector shown in Figure 5;

Figure 7 is a cross-sectional view along line 7-7 of Figure 6;

Figure 8 is a front plan view of the connector of Figure 5;

Figure 9 is a cross-sectional view along line 9-9 of Figure 8;

Figure 10 is a top plan view of a stamped and formed lead frame which provides adjacent contacts for the housing of Figure 5;

Figure 11 is a view showing an insulated web of material overmolded on the lead frame of Figure 10;

Figures 12A and 12B show terminal subassemblies removed from the lead frame of Figure 11;

Figure 13 is a cross-sectional view along line 13-13 of Figure 11;

Figure 14 is a cross-sectional view along line 14-14 of Figure 12A;

Figure 15 is a cross-sectional view along line 15-15 of Figure 12B;

Figure 16 is a front plan view of an assembled connector;

Figure 17 is a partial cross-sectional view along line 17-17 of Figure 16;

Figure 18 is a lower plan view of the assembled connector of Figure 16;

Figure 19 is a front plan view showing the connectors in place within the cage;

Figures 20 and 21 show top and bottom perspective views of a module that is insertable in the cage of Figure 1 and matable with the connector.

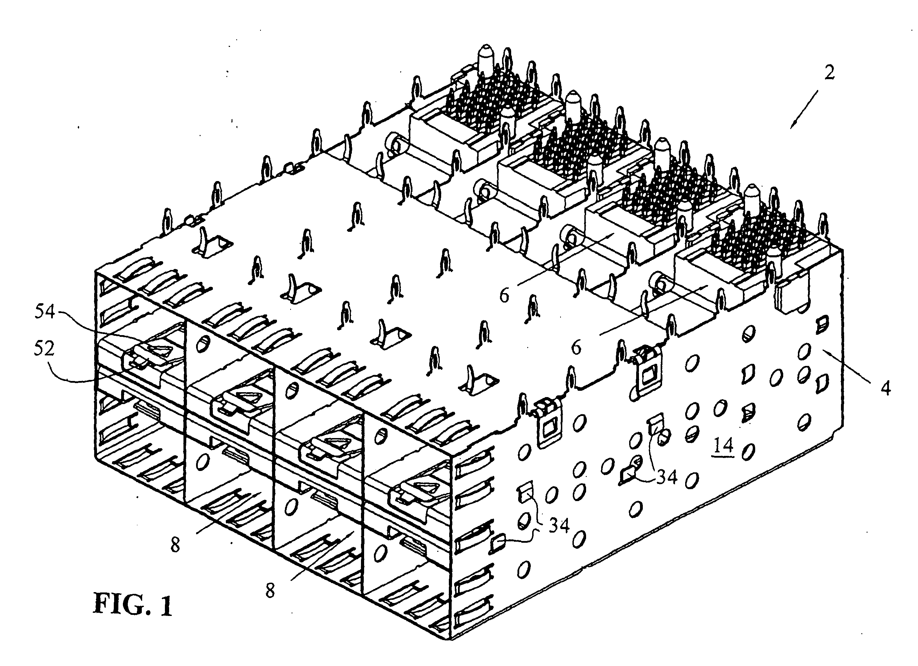

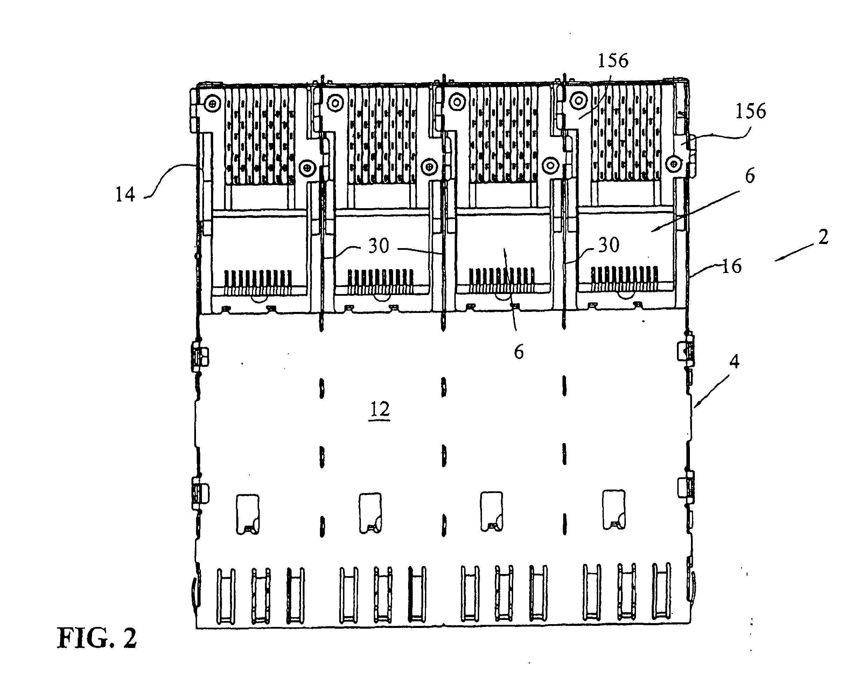

With reference first to Figures 1 and 2, an electrical connector assembly 2 comprises a stamped and formed shielding cage 4 having a plurality of connector assemblies 6 positioned therein. It should be appreciated from Figure 1 that the connector assembly is intended for placement on a motherboard and includes a plurality of module-receiving ports 8, as will be described herein.

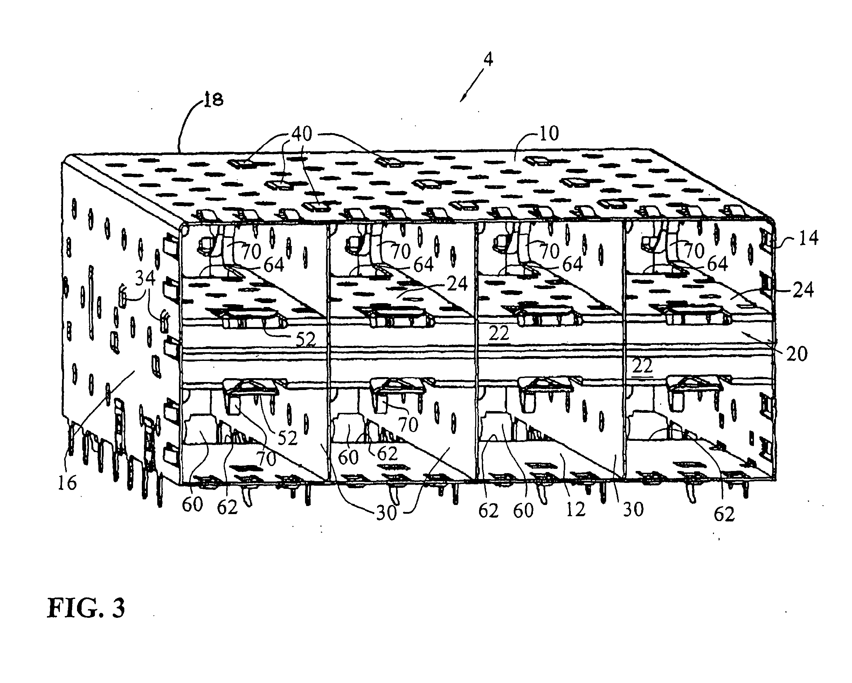

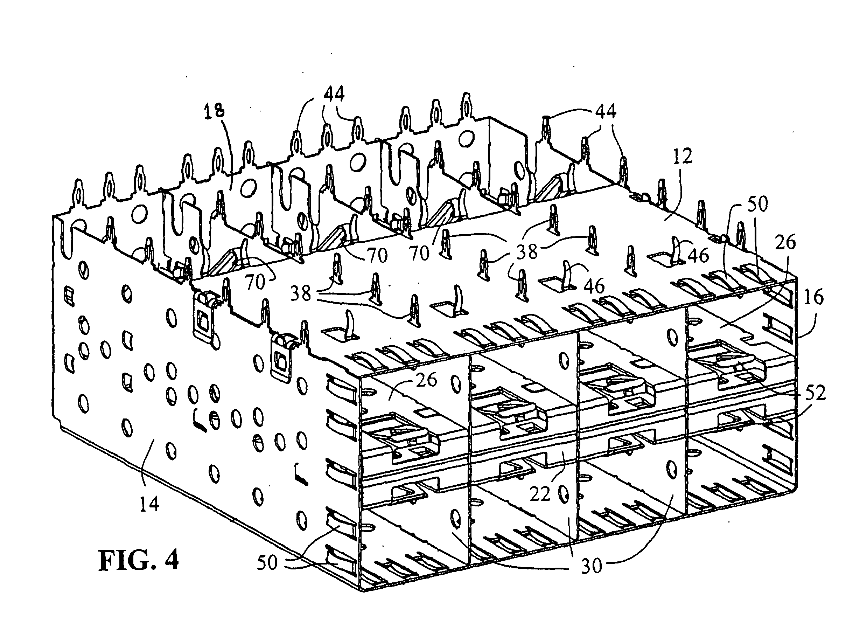

With reference to Figures 3 and 4, the shielding cage 4 is shown less the electrical connectors 6, and is shown having an upper wall 10, a lower wall 12, side walls 14 and 16, and a rear wall 18, which together define the general enclosure for the cage 4. The cage 4 is subdivided into rows by way of an intermediate wall 20, having a front face 22 with an upper wall 24 (Figure 3) and a lower wall 26 (Figure 4). Meanwhile, the cage 4 is divided into columns by way of vertically extending divider walls 30. The intermediate wall 20 is retained in place by tabs 34, which extend from side edges of the upper and lower walls 24, 26, and which extend through the side walls 14, 16, as best shown in Figures 1 and 3. The vertical dividers 30 are positioned and retained in the cage by way of printed circuit board tines 38 (Figure 4) extending through apertures in the lower wall 12 and by way of bent-over tab portions 40 (Figure 3) which extend through apertures in the upper wall 10.

The cage 4 has numerous features allowing the grounding of the cage to a motherboard and/or a further panel. As shown best in Figure 4, in addition to printed circuit board tines 38, the perimeter of the cage includes a plurality of printed circuit board tines at 44, which are profiled to both mechanically hold the cage to a motherboard as well as to ground the cage thereto. Resilient tongues 46 are also struck from lower wall 12 and provide grounding of the cage to the motherboard. Around the perimeter of the cage towards the front edge thereof, the cage includes a plurality of resilient tongues 50, which are profiled to engage an edge of an opening through which the cage is inserted. The upper and lower walls 24, 26 include grounding tabs 52 adjacent a front edge thereof for grounding a module to be inserted therein. Finally, the grounding tabs have latching openings 54, as will be more fully described herein.

With reference now to Figure 3, the cage 4 also includes a communication opening, generally designated by reference numeral 60 and which is formed by opening 62 extending through lower wall 12 (Figure 3), opening 64 extending through upper wall 24 (Figure 3), and a corresponding similar opening that extends through lower wall 26 (not shown). The communication opening 60 is positioned at the rearward side of the cage 4 for access to connector member 6, as will be described in further detail.

Finally, with reference to Figures 3 and 4, the cage also includes module kick-out springs 70 each defined by a reversely bent loop of stamped and formed material which is defined into a forwardly directed spring.

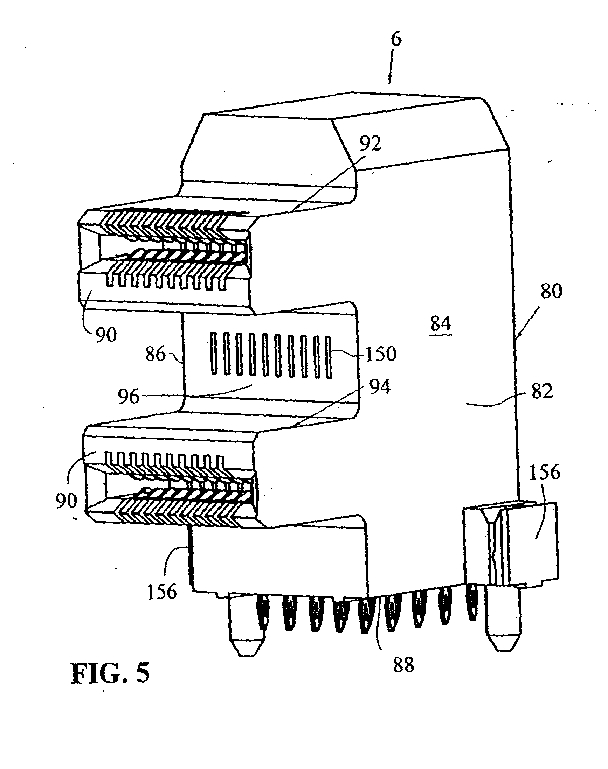

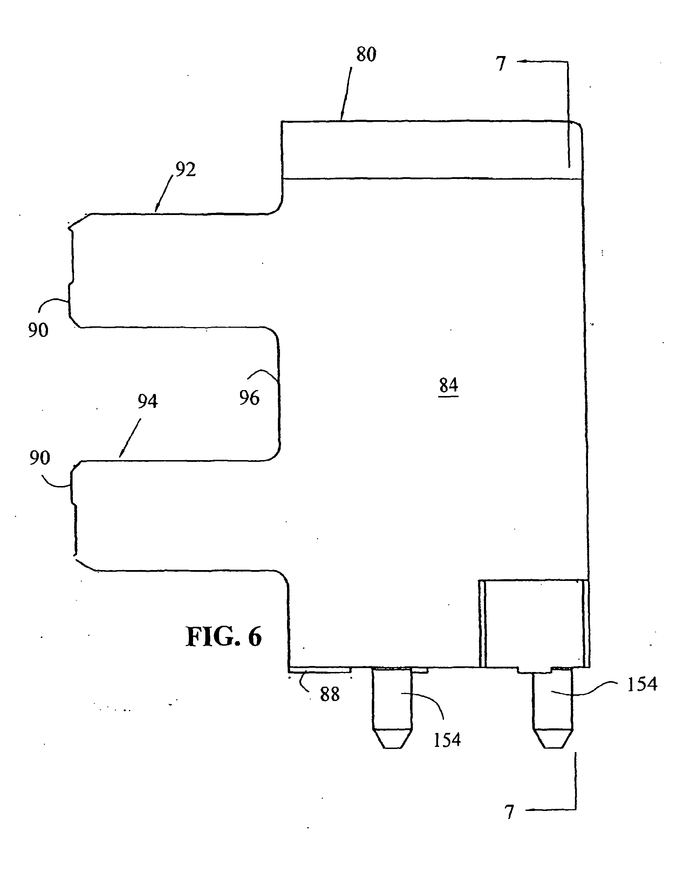

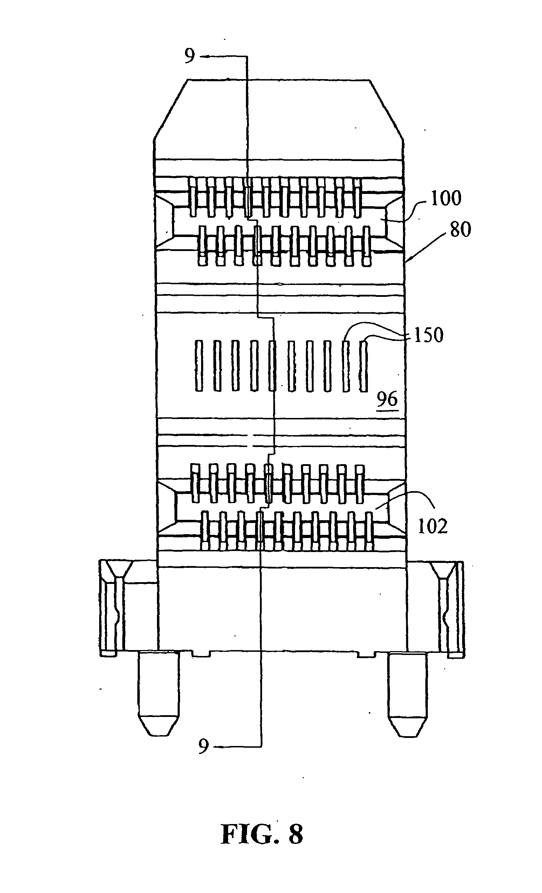

Referring now to Figures 5 through 9, connector 6 will be described in further detail. As best shown in Figure 5, the connector 6 includes housing 80, which is defined by an upstanding body portion 82 having side walls 84, 86, a circuit board mounting face 88, and mating faces 90. Upper and lower extensions 92 and 94 extend from the body portion 82 to define the mating faces 90. A recessed face 96 is defined between the upper and lower extensions 92, 94 at the front of the body portion 82. Finally, as shown best in Figure 8, circuit card receiving slots 100 and 102 extend inwardly from the mating faces 90 and through the upper and lower extensions 92, 94, into the housing 80.

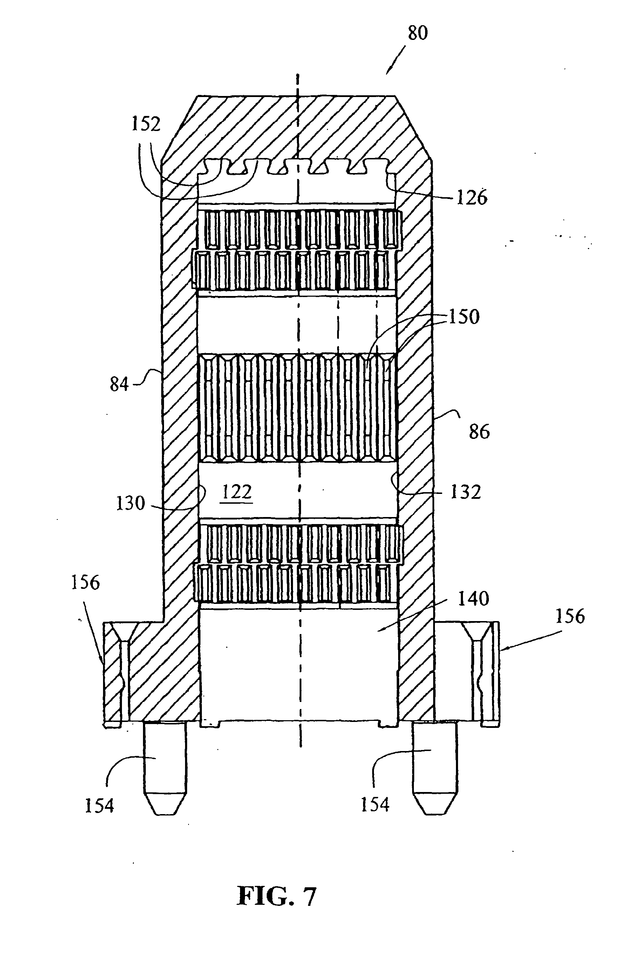

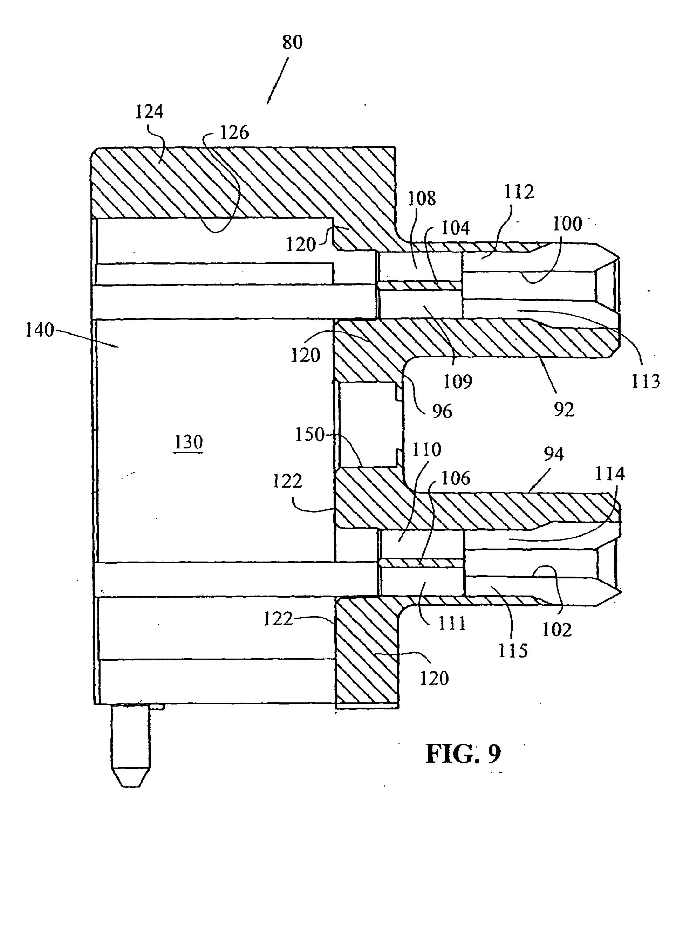

With reference now to Figures 7 through 9, the interior of the housing 80 will be described in greater detail. As shown in Figure 9, slots 100 and 102 extend rearwardly into their respective extensions 92, 94 to respective intermediate walls 104, 106, thereby defining upper and lower terminal-receiving passageways 108-111 in the upper and lower extensions. It should be noted that Figure 9 is a staggered cross-section through housing as shown in Figure 8. As shown in Figure 9, the passageways 108-111 are aligned with slots 112-115, respectively, which flank the slots 100, 102 and which are open to the front face 90. Also shown in Figure 9, the extensions 92 and 94 extend from a front wall 120 which defines an inner surface 122. The housing 80 also includes a top wall portion 124 defining an inner surface 126. Furthermore, as best shown in Figure 7, side walls 84 and 86 define inner surfaces 130 and 132. Thus, a rear cavity 140 is defined in the housing 80, rearward of front wall 120, bounded by surfaces 122, 126, 130 and 132. This cavity 140 receives a terminal module as will be described in greater detail.

With respect to the terminal module, housing 80 includes a plurality of locking slots 150, which extend through the recessed face 96, as best shown in Figures 5 and 8, and extend inwardly through front wall 120 to inner surface 122, as best shown in Figures 7 and 9. Furthermore, as shown in Figure 7, housing 80 includes a plurality of dove-tail slots 152 formed along inner surface 126 for aligning the modules, as will be described herein. The housing 80 also includes aligning posts 154 and latching members 156 positioned at opposite corners of the housing, as best shown in Figures 5 and 7. Latching members 156 are profiled for slidable receipt over edges of divider walls 30, and over edges of side walls 14 and 16, as will be described further herein.

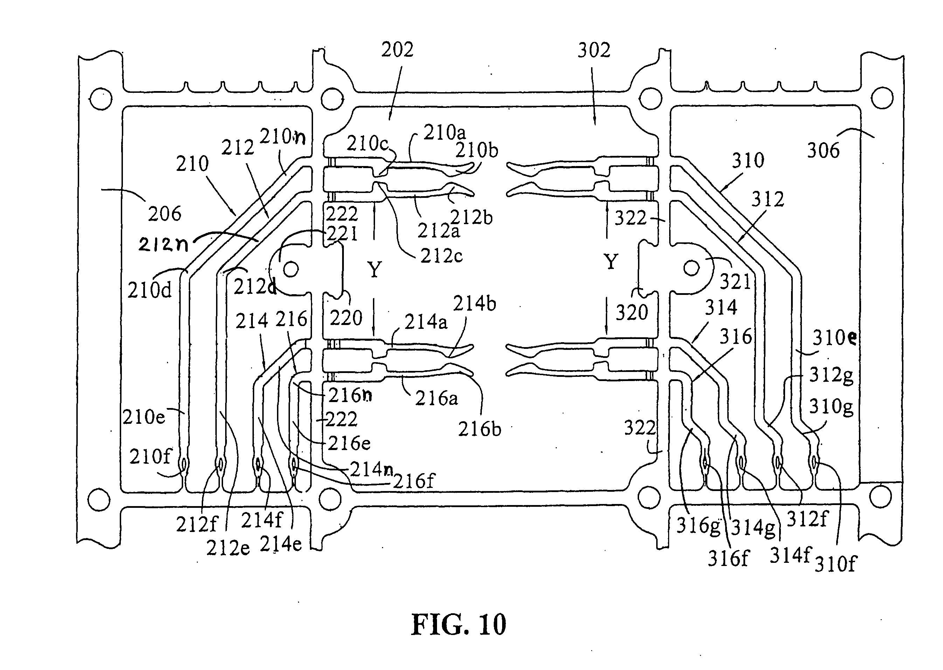

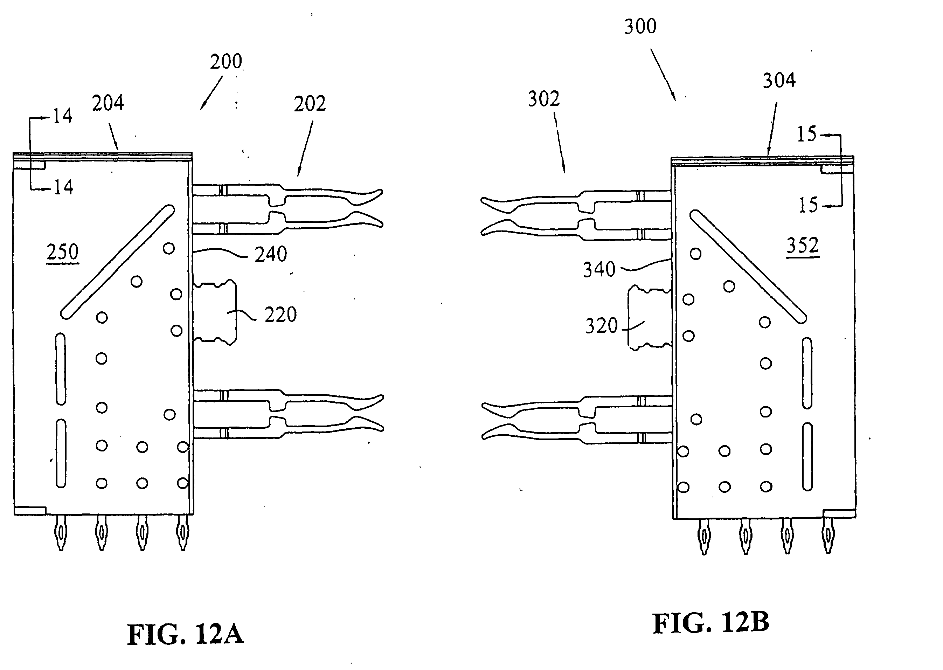

With reference now to Figures 10 through 12B, the terminal modules will be described in greater detail. As shown in Figures 12A and 12B, two terminal modules 200 and 300 each include a terminal lead frame 202 and 302 overmolded by a web of plastic material 204 and 304. As shown best in Figure 10, lead frames 202 and 302 are stamped from a common sheet of material which can be carried by carrier strips 206, 306. Each lead frame 202, 302 is comprised of four terminals including an upper pair of terminals 210, 212; 310, 312, and a lower pair of terminals 214, 216; 314, 316. As shown in Figure 10, the upper and lower pairs are separated by a vertical distance Y, and retention tabs 220, 320 are positioned in that vertical spacing and held in place by a carrier strip portion 222, 322, respectively.

Each of the pairs of terminals are substantially identical, yet are mirror images of each other, as will be described herein. Terminal 210 includes a cantilever beam section 210a defining a forward contact section 210b adjacent a front end of the terminal. Terminal 210 further includes a locking tab portion 210c. Terminal 210 further includes an intermediate angled portion 210n, which transitions the terminal from a horizontal to a vertical orientation, and transitions at 210d into an elongate extension portion 210e, which compensates for the horizontal spacing Y and which is interconnected to compliant pin portion 210f. As shown in Figure 10, each of the terminals has generally equivalent components, although the terminals 214 and 216 have elongate extension portions 214e, 216e which are substantially shorter than the equivalent elongate extension portions 210e, 212e of the terminals 210, 212. The terminals 214, 216 also have angled intermediate portions 214h, 216h and compliant pin portions 214f, 216f.

As shown in Figure 10, terminal lead frame 302 is virtually identical to lead frame 202, with the exception that each of the terminals includes a kinked leg portion 310g-316g, which generally steps the compliant pin portions 310f-316f rearwardly, relative to the corresponding compliant pin portions 210f-216f, respectively.

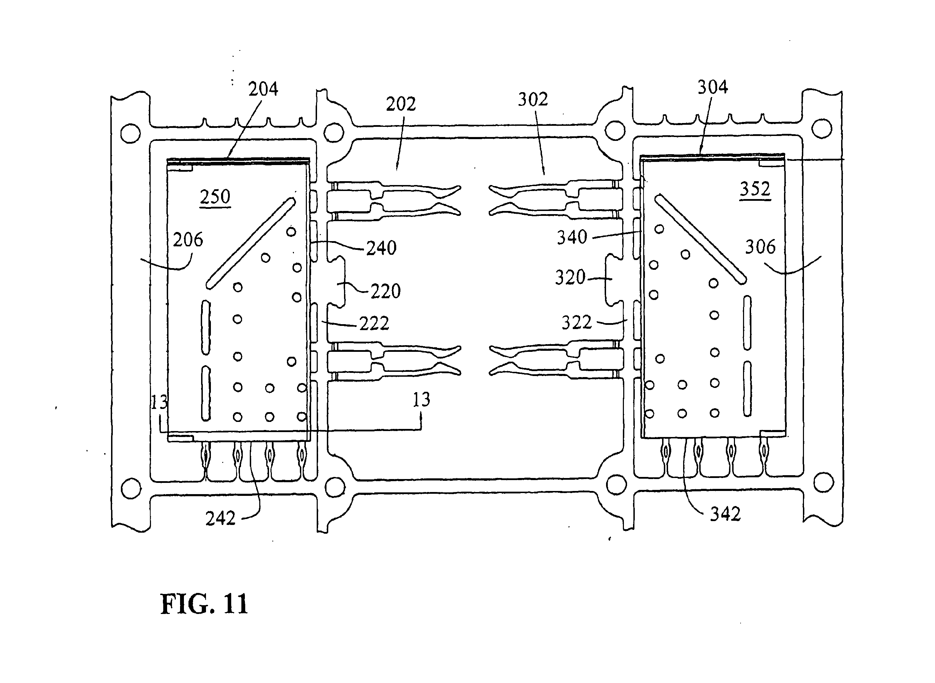

With respect now to Figure 11, with the lead frame as shown and described in Figure 10, molded webs 204, 304 are insert-molded over a portion of the lead frame, leaving the cantilever beam portions of each of the terminals extending forwardly from front edges 240, 340, respectively, of the molded webs. In a similar nature, the compliant pin portions 210f-216f extend downwardly from a lower edge 242, 342 of the molded webs 204, 304. As shown in Figures 10 and 11, each of the tab portions 220, 320 includes an eyelet portion, 221, 321 which is overmolded adjacent the front edges 240, 340, yet the forward portion of the tabs 220, 320 extends outwardly from the front edge. When the overmolded webs 204, 304 are placed in the position shown in Figure 11, lead frames 206, 306 and 222, 322 can be stamped free from the lead frame, thereby defining the completed inserts as shown in Figures 12A and 12B as 200 and 300, respectively.

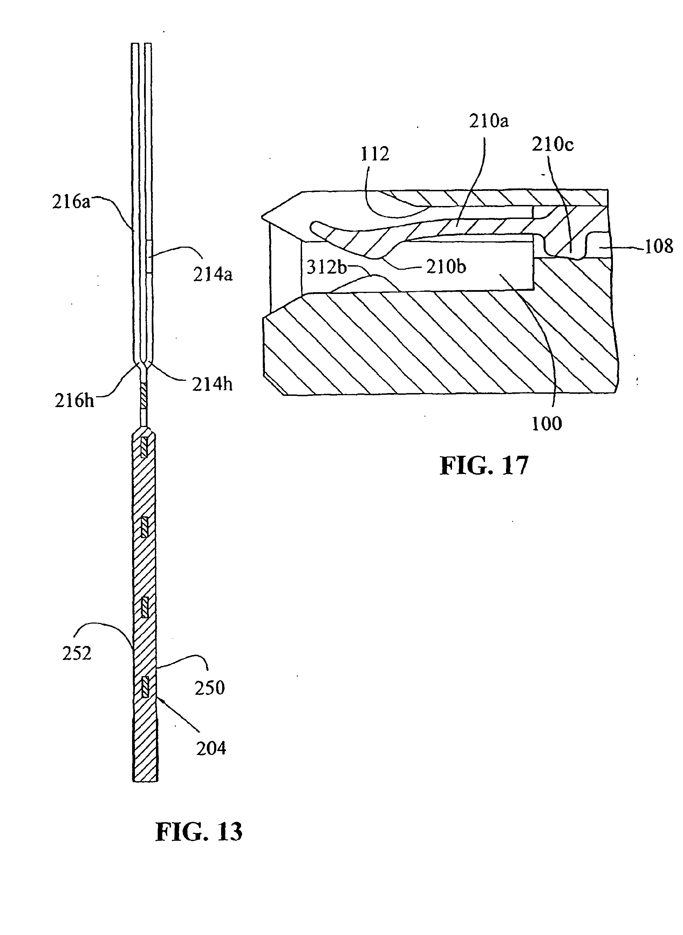

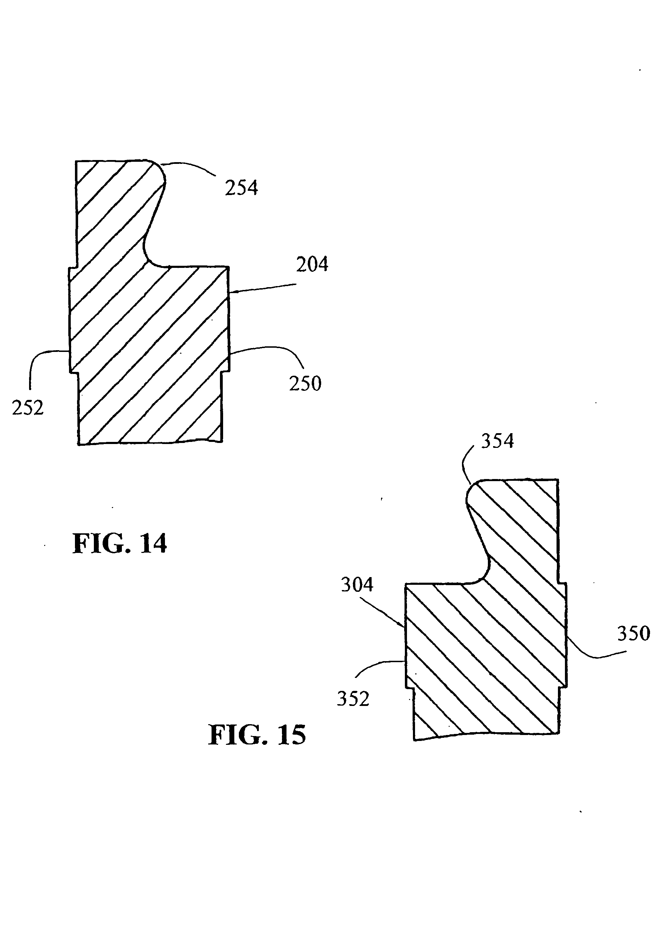

With reference now to Figure 13, the configuration of the cantilever beam terminals 214a and 216a is shown in greater detail. As shown, each of the terminals is kinked at 214h and 216h to stagger the cantilever portions 214a and 216a. Furthermore, as shown in Figure 13, the web 204 includes side surfaces 250, 252, whereas molded insert 304 includes side surfaces 350, 352 (Figures 12B, 15). As shown best in Figures 14 and 15, the top edge of the molded inserts are also configured as cooperative dove-tail portions, such that, when molded inserts 204 and 304 are positioned in a stacked relation, with surface 252 of insert 204 positioned against surface 350 of insert 304, the two profiles 254 and 354 provide a dove-tail tongue configuration. It should be appreciated that this tongue configuration is profiled as the dove-tail slot 152, as shown in Figure 7. With the components as described above, the assembly of the connector assembly and the connector assembly to the cage will now be described.

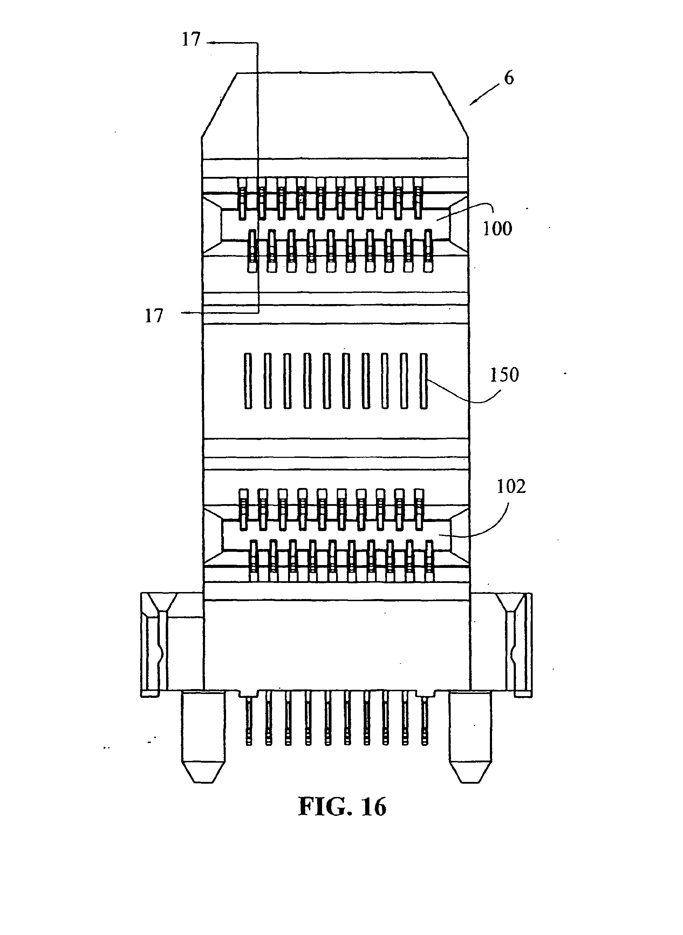

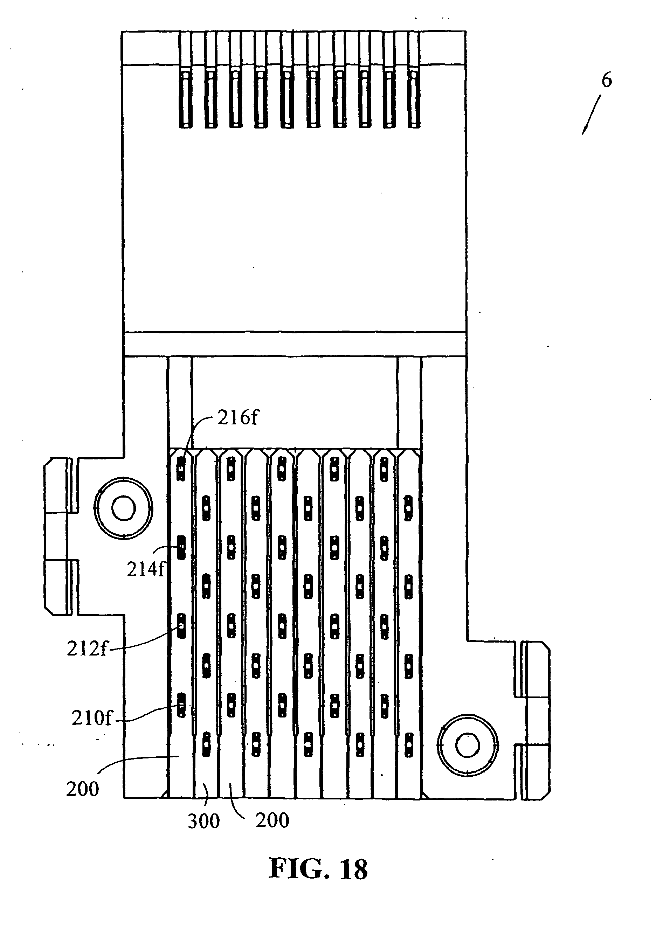

As mentioned above, each of the terminal subassemblies 200, 300 are positioned stacked one against the other, with surface 350 of molded insert 304 positioned against surface 252 of molded insert 204. These molded inserts may now be inserted into the cavity 140 of housing 80, such that the individual terminals align with respective passageways 108-111. Continued movement of the inserts into the housing causes the terminals to be positioned within respective slots 112-115 (Figure 9). A continued force causes locking tabs 220, 320 to be inserted into slots 150, thereby locking the inserts in place with the front edge 240 of the molded inserts positioning molding inserts 204, 304 fully within the cavity, with surfaces 240, 340 against inner surface 122 of housing 80. As also mentioned above, the dove-tail configuration 254, 354 allows alignment of the individual arrays with the dove-tail slots 152. The cantilever beams are positioned within housing 80, whereby tab portions (such as 210c) are interference fitted within the respective passageway 108, and the tab portion 210c acts as a fulcrum with the cantilever beam portion 210a extending forwardly, with a portion of beam 210a in slot 212, and the contact point 210b extending into the receiving slot 100. It should be appreciated that each of the cantilever beams is so situated in their respective passageways and slots. Thus, the fully assembled configuration of connector 6 is shown in Figures 16 and 18.

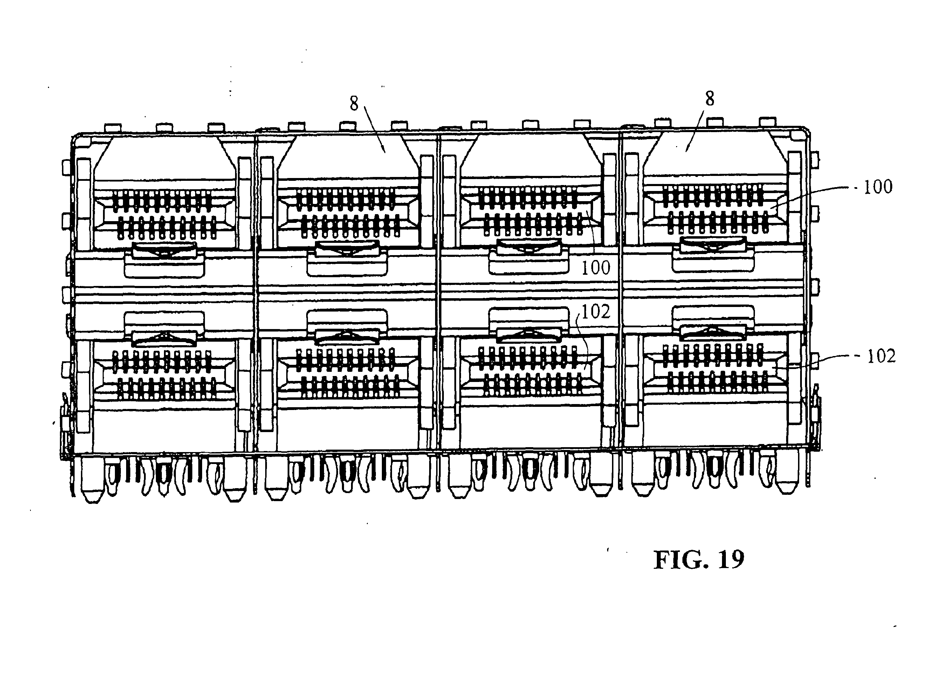

Connector 6 can now be positioned within the cage 4, through lower wall 12 to the position shown in Figures 1, 2 and 19. As best shown in Figure 2, each of the connectors is clipped to the cage, whereby latching members 156 in opposite corners of the connector are clipped to either an outside wall 14, 16 or an internal divider wall 30. As shown best in Figure 2, due to the staggered configuration of the latching members 156, the connector housings 80 can be positioned in a closely aligned array. As also shown best in Figure 19, each of the printed circuit card receiving slots 100, 102 is aligned within a respective one of the module-receiving ports 8 for receipt of a module.

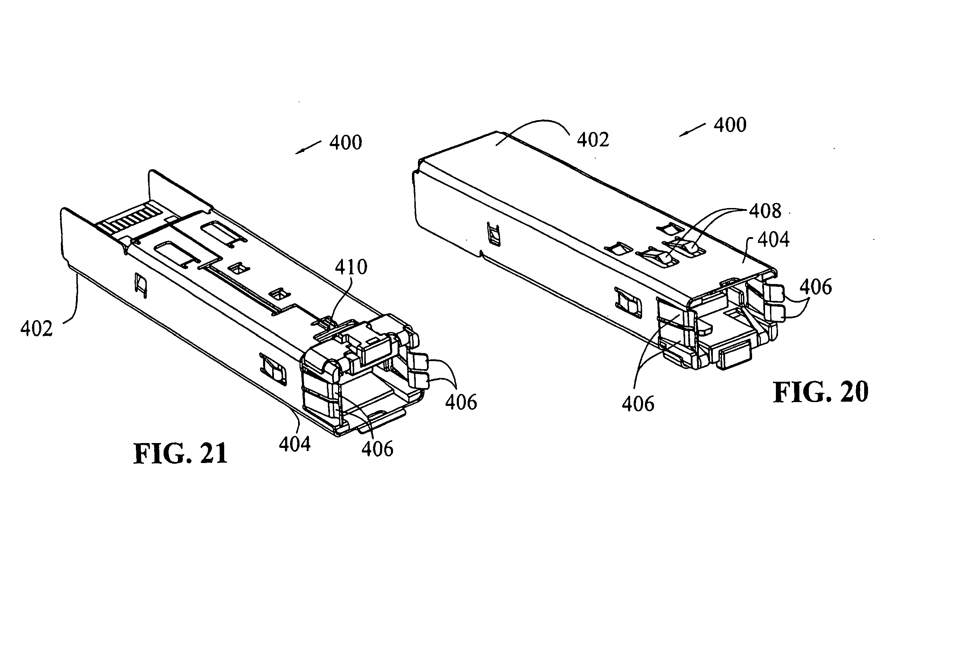

Finally, as shown in Figures 20 and 21, a small form-factor pluggable (SFP) module 400 is shown having a circuit card at one end 402 thereof for interconnection into slots 100, 102 and into interconnection with the plurality of electrical terminals. The module 400 further includes an electrical interconnection within the module to an interface at end 404, such as a copper interface in the way of a modular jack, or to a fiber optic connector for further interfacing. The module also includes grounding tabs 406, 408 and a raised embossment 410 (Figure 21). This embossment latches into triangular shaped openings 54 (Figure 1) of the grounding tabs 52. This allows for easy extraction of the modules 400 as the grounding tabs are accessible from the front end of the cage. These SFP modules are similar to those known as Tyco Part Number 1367251 and as shown in U.S. Patent No. 6,517,382, incorporated herein by reference.

Advantageously, the assembly of the entire electrical connector assembly is simplified by the availability of the connector 6 having two printed circuit card receiving slots 100, 102, which further increases the port density and efficiency of the overall system.

## Claims

1. An electrical connector assembly comprising a shielding cage (4) having an upper wall (10), a lower wall (12), side walls (14, 16), a rear wall (18), and an intermediate wall (20) defining a plurality of module-receiving ports (8) arranged in an array of rows and columns, the lower wall and the intermediate wall forming a communication opening (60) between the module-receiving ports in each said column, and an electrical connector (6) disposed in each said communication opening, each said electrical connector including an insulative housing (80) having a circuit board mounting face (88) and a front mating face (90), the front mating face including upper and lower card-receiving slots (100, 102) extending horizontally across the front mating face and positioned one above the other for alignment with respective upper and lower module-receiving ports in each said column, wherein each said electrical connector includes a plurality of terminals arranged in an array comprising upper (210, 212; 310, 312) and lower (214, 216; 314, 316) terminal pairs, said upper terminal pair having cantilever beam contacts (210a, 212a) flanking said upper card-receiving slot, and said lower terminal pair having cantilever beam contacts (214a, 216a) flanking said lower card-receiving slot, **characterized in that**:
each said terminal array includes a stamped lead frame (202, 302) overmolded with a web of plastic material (204, 304), a locking tab (220, 320) is overmolded in said web of plastic material, and said locking tab extends outwardly from a front edge (240, 340) of said web and engages in a slot (150) in said housing.

2. The electrical connector assembly of claim 1, wherein said housing includes upper and lower extensions (92, 94) which extend from a body portion of said housing to said front mating face, and said upper and lower card-receiving slots are positioned in respective said upper and lower extensions.

3. The electrical connector assembly of claim 1, wherein a plurality of said terminal arrays are arranged side-by-side in a cavity in said housing.

## Patentansprüche

1. Elektrische Verbinderanordnung, die aufweist: einen Abschirmkäfig (4) mit einer oberen Wand (10), einer unteren Wand (12), Seitenwänden (14, 16), einer hinteren Wand (18) und einer Zwischenwand (20), die eine Vielzahl von Modulaufnahmeöffnungen (8) definieren, die in einer Anordnung von Reihen und senkrechten Reihen angeordnet sind, wobei die untere Wand und die Zwischenwand eine Kommunikationsöffnung (60) zwischen den Modulaufnahmeöffnungen in jeder senkrechten Reihe bilden; und einen elektrischen Verbinder (6), der in jeder Kommunikationsöffnung angeordnet ist, wobei ein jeder elektrischer Verbinder ein isolierendes Gehäuse (80) mit einer Leiterplattenmontagefläche (88) und einer vorderen Eingriffsfläche (90) umfasst, wobei die vordere Eingriffsfläche obere und untere Kartenaufnahmeschlitze (100, 102) umfasst, die sich horizontal über die vordere Eingriffsfläche erstrecken und einer über dem anderen für eine Ausrichtung mit den jeweiligen oberen und unteren Modulaufnahmeöffnungen in jeder senkrechten Reihe positioniert sind, wobei ein jeder elektrischer Verbinder eine Vielzahl von Anschlussklemmen umfasst, die in einer Anordnung angeordnet sind, die obere (210, 212; 310, 312) ein untere Klemmenpaare (214, 216; 314, 316) aufweist, wobei das obere Klemmenpaar Kragträgerkontakte (210a, 212a) aufweist, die den oberen Kartenaufnahmeschlitz flankieren, und wobei das untere Klemmenpaar Kragträgerkontakte (214a, 216a) aufweist, die den unteren Kartenaufnahmeschlitz flankieren, **dadurch gekennzeichnet, dass**:
jede Klemmenanordnung einen gestanzten Leiterrahmen (202, 302) umfasst, über den ein Steg aus Kunststoffmaterial (204, 304) geformt ist, wobei eine Sperrnase (220, 320) im Steg aus Kunststoffmaterial darüber geformt ist, und wobei sich die Sperrnase nach außen von einem vorderen Rand (240, 340) des Steges erstreckt und in einem Schlitz (150) im Gehäuse in Eingriff kommt.

2. Elektrische Verbinderanordnung nach Anspruch 1, bei der das Gehäuse obere und untere Erweiterungen (92, 94) umfasst, die sich von einem Körperabschnitt des Gehäuses zur vorderen Eingriffsfläche erstrecken, und wobei die oberen und unteren Kartenaufnahmeschlitze in jeweiligen oberen und unteren Erweiterungen positioniert sind.

3. Elektrische Verbinderanordnung nach Anspruch 1, bei der eine Vielzahl der Klemmenanordnungen nebeneinander in einem Hohlraum im Gehäuse angeordnet ist.

## Revendications

1. Assemblage de connecteur électrique, comprenant une cage de blindage (4) comportant une paroi supérieure (10), une paroi inférieure (12), des parois latérales (14, 16), une paroi arrière (18) et une paroi intermédiaire (20) définissant plusieurs ports de réception de modules (8) agencés dans un ensemble de rangées et de colonnes, la paroi inférieure et la paroi intermédiaire formant une ouverture de communication (60) entre les ports de réception de module dans chaque dite colonne, et un connecteur électrique (6) agencé dans chaque dite ouverture de communication, chaque dit connecteur électrique englobant un boîtier isolant (80) comportant une face de montage de la carte à circuit imprimé (88) et une face d'accouplement avant (90), la face d'accouplement avant englobant des fentes supérieure et inférieure de réception de la carte (100, 102) s'étendant horizontalement à travers la face d'accouplement avant et positionnées l'une au-dessus de l'autre en vue d'un alignement avec les ports supérieur et inférieur de réception du module dans chaque dite colonne, chaque dit connecteur électrique englobant plusieurs bornes agencées dans un agencement comprenant des paires supérieure (210, 212; 310, 312) et inférieure (214, 216; 314, 316) de bornes, ladite paire supérieure de bornes comportant des contacts de barre en porte-à-faux (210a, 212a) flanquent ladite fente supérieure de réception de la carte, et ladite paire inférieure de bornes comportant des contacts de barre en porte-à-faux (214a, 216a) flanquant ladite fente inférieure de réception de la carte, **caractérisé en ce que**:
chaque dit ensemble de bornes englobe une grille de connexion estampée (202, 302) surmoulée d'une bande de matériau plastique (204, 304), une patte de verrouillage (220, 320) étant surmoulée dans ladite bande de matériau plastique et ladite patte de verrouillage s'étendant vers l'extérieur à partir d'un bord avant (240, 340) de ladite bande et s'engageant dans une fente (150) dans ledit boîtier.

2. Assemblage de connecteur électrique selon la revendication 1, dans lequel ledit boîtier englobe des extensions supérieure et inférieure (92, 94) s'étendant à partir d'une partie de corps dudit boîtier vers ladite face d'accouplement avant, lesdites fentes supérieure et inférieure de réception de la carte étant positionnées dans lesdites extensions supérieure et inférieure respectives.

3. Assemblage de connecteur électrique selon la revendication 1, dans lequel plusieurs desdits ensembles de bornes sont agencés côte à côte dans une cavité dans ledit boîtier.
